# EUROPEAN PATENT APPLICATION

(11) **EP 2 620 530 A1**
(43) Date of publication of application: **31.07.2013**
(21) Application number: 11826731.9
(22) Date of filing: 08.09.2011
(51) Int. Cl.: C25D 7/06, C23C 28/00, C25D 3/38, C25D 5/10, H05K 1/09, H05K 3/38

(54) **METHOD FOR MANUFACTURING COPPER FOIL FOR PRINTED CIRCUIT BOARD AND COPPER FOIL FOR PRINTED CIRCUIT BOARD**

(30) Priority: 24.09.2010 JP 2010214475
(71) Applicant: JX Nippon Mining & Metals Corporation, Tokyo 100-8164 (JP)
(72) Inventor: MORIYAMA Terumasa, Hitachi-city Ibaraki 317-0056 (JP)
(74) Representative: Liesegang, Eva
(86) International application number: PCT/JP2011/070447
(87) International publication number: WO 2012/039285

(57) **Abstract**

A method of manufacturing a copper foil for a printed wiring board, characterized in that a roughened layer of roughening copper grains is formed on at least one surface of the copper foil by using an electrolytic bath of sulfuric acid and copper sulfate, and the electrolytic bath contains tungsten ions and/or arsenic ions and further contains an alkyl sulfate-based anionic surfactant. The object of the present invention is to provide a method of manufacturing a copper foil for a printed wiring board, wherein in particular a roughened layer on the copper foil can be improved to enhance the adhesive strength between the copper foil and a resin substrate without deteriorating other properties of the copper foil.

## Description

### TECHNICAL FILED

The present invention relates to a copper foil for a printed wiring board having excellent adhesiveness with a resin, and to a manufacturing method thereof. Specifically, the present invention provides a copper foil capable of showing stronger peel strength when used in combination with a semiconductor package substrate and a liquid crystal polymer substrate commonly having weaker adherence with a copper foil compared with a general-purpose epoxy resin-based substrate (such as FR-4), and provides a manufacturing method thereof.

### BACKGROUND ART

A printed wiring board is generally fabricated according to the following steps. First, a copper foil is adhesively-laminated onto a substrate such as a synthetic resin under high temperature and high pressure. Next, in order to form the intended conductive circuit on the substrate, a pattern equivalent to the intended circuit is printed on the copper foil using a material such as an etching-resistant resin.
Then an unwanted exposed region of the copper foil is removed by etching treatment. After etching, the printed region made of a material such as a resin on the remaining copper (a circuit part) is removed to form a conductive circuit on the substrate. Finally, an intended element is soldered to the formed conductive circuit to form various printed circuit boards for electronic devices. Eventually, it is bonded to a resist or a build-up resin substrate.

Primarily, a roughened surface of a copper foil, which is to be an adherend surface to be bonded to a resin, is required to have sufficient peel strength with a resin substrate, where the peel strength is sufficiently maintained even after high-temperature heating, wet processing, soldering, chemical treatment and the like.
In general, methods of increasing the peel strength between a copper foil and a resin substrate typically include a method of attaching a large amount of roughening grains on a raw copper foil having an enhanced surface profile (unevenness, roughness).
However, when such a copper foil having an enhanced surface profile (unevenness, roughness) is used for a semiconductor package board in which a particularly fine circuit pattern is required to form among printed wiring boards, unwanted copper grains remain upon circuit etching to cause problems such as insulation failure between circuit patterns.
For this reason, as a copper foil for a fine circuit including a semiconductor package board, a so-called low-profile copper foil where minimum roughening treatment enough to assure adherence with a substrate is performed on a raw copper foil having a reduced profile is used. The adherence (peel strength) between such a low-profile copper foil and a resin tends to be decreased as compared with a common copper foil for a printed wiring board due to the effect of its low profile (unevenness, a degree of roughness, roughness).

In general, the peel strength between a copper foil and a resin substrate also tends to be further decreased because in addition to the aforementioned lowered profile of a copper foil, the adherence between a copper foil and a resin substrate for a semiconductor package board or a liquid crystal polymer substrate is lower as compared with that of a general-purpose epoxy resin-based substrate such as FR-4.
Therefore, a copper foil for the fine wiring needs both a reduced profile of an adherend surface to be bonded to a resin substrate and a high adherence (peel strength) to the resin substrate.

Further, electronic devices such as personal computers and mobile communications require a printed wiring board and a copper foil which can accommodate increased speed and increased capacity of communications accompanied by electric signals of increasingly higher frequency. When a frequency of an electric signal is 1 GHz or more, the skin effect, in which an electric current flows only on the surface of a conductor, becomes significant, and an uneven surface causes the change in electric current transmission paths, resulting in a non-negligible increase in impedance. In view of this, reduced surface roughness of a copper foil is also desirable. A liquid crystal polymer substrate, which is increasingly used in recent years because of its advantageously small transmission loss in high-frequency electric signals, has particularly decreased adherence with a copper foil. Therefore, again, both a reduced profile of a copper foil and a high adherence (peel strength) need to be satisfied at the same time.

In general, in a method of treating the surface of a copper foil for a printed wiring board, first, roughening treatment is generally performed in which fine grains made of copper and copper oxide are attached on the surface of a raw rolled copper foil or electrolytic copper foil in order to increase adhesive strength (peel strength) between the copper foil and a resin. Subsequently, cover plating is performed in a copper sulfate plating bath in order to prevent detachment of the roughening grains and to improve the adherence.
Further, a heat resistant layer (a barrier layer) such as brass or zinc is formed thereon in order to confer heat and weather resistance to the copper foil.
Then rust proof treatment such as an immersion or electrolytic chromate treatment or electrolytic chromium and zinc treatment is performed in order to prevent surface oxidation and the like during transportation or storage, thereby obtaining a product.

Among these, the roughened layer particularly plays the most important role on giving the adhesive strength (peel strength) between the copper foil and the resin substrate.

In general, a heat resistant and rust proof layer is formed over the adherend surface, which is a surface to be bonded to a resin, of a copper foil for a printed wiring board. Various copper foils provided with a coating layer of Zn, Cu-Ni, Cu-Co, Cu-Zn and the like as examples of metals or alloys to form a heat-resistant layer are actually used (for example, see Patent Document 3).
Among these, a copper foil provided with a heat resistant layer of Cu-Zn (brass) is widely used in industry because it shows no stain in a resin layer when laminated over a printed circuit board of an epoxy resin and the like, and because it has excellent properties such as less deteriorated peel strength after high-temperature heating.
A method of forming this heat resistant layer of brass is described in detail in Patent Document 4 and Patent Document 5.

Moreover, a method of improving adherence with a resin substrate by performing chromate treatment on the above-mentioned heat resistant layer, and then allowing a silane coupling agent to be absorbed in the chromate-treated surface is used widely in industry.

The above-mentioned methods for roughening treatment may include several known techniques. For example, Patent Document 8 discloses a copper foil for a printed circuit having a roughened layer on the adherend surface of the copper foil, the roughened layer comprising many protruding electrodepositions containing one or two types of chromium or tungsten. The layer is intended to improve adhesive strength and heat resistance, and to suppress powder fall.

Furthermore, Patent Document 9 discloses a copper foil for a printed circuit having, on the adherend surface of the copper foil, a roughened layer comprising many protruding electrodepositions, which are of a metal in Group 1 containing one or two types of chromium or tungsten, and a metal in Group 2 selected from nickel, iron, cobalt and zinc. The layer is intended to improve adhesive strength and heat resistance, and to suppress powder fall, which is proposed as an improved technology of Patent Document 8.
In addition, Patent Document 10 proposes a roughened copper foil having, on the adherend surface of the copper foil, a composite metal layer comprising one or more metals of copper, tungsten and molybdenum, and one or more metals selected from nickel, cobalt, iron and zinc; and further having a roughened layer on the composite metal layer.

Further, Patent Document 11 proposes a technology of performing roughening treatment by using a plating bath wherein a metal selected from iron, nickel, cobalt, molybdenum, tungsten, titanium and aluminium, and polyethylene glycol are added to an acidic copper plating bath mainly containing copper sulfate and sulfuric acid so that even if a copper foil having unevenness on the surface is used when roughening treatment is performed on the surface of the copper foil, copper grains are not concentrated at convex regions but also attached to concave regions to evenly form knob-shaped copper grains, thereby achieving the increased adhesive strength, less residual copper upon etching, and better etching properties. Furthermore, Patent Document 12 proposes a technology of performing roughening treatment by using a plating bath where gelatin is added instead of the above-mentioned polyethylene glycol.
Although these additives are formulated for an acidic copper plating bath mainly containing copper sulfate and sulfuric acid, their effects are limited. Therefore, further improvement is demanded.

[Patent Document 1] Japanese Laid-Open Patent Publication No. H8-236930
[Patent Document 2] Japanese Patent No. 3459964
[Patent Document 3] Japanese Patent Publication No. S51-35711
[Patent Document 4] Japanese Patent Publication No. S54-6701
[Patent Document 5] Japanese Patent No. 3306404
[Patent Document 6] Japanese Patent Application No. 2002-170827
[Patent Document 7] Japanese Laid-Open Patent Publication No. H3-122298 [Patent Document 8] Japanese Patent No. 2717911
[Patent Document 9] Japanese Patent No. 2920083
[Patent Document 10] Japanese Laid-Open Patent Publication No. 2001-226795
[Patent Document 11] Japanese Laid-Open Patent Publication No. 2005-353919
[Patent Document 12] Japanese Laid-Open Patent Publication No. 2005-353920

### SUMMARY OF INVENTION

### [Technical Problem]

An object of the present invention is to provide a copper foil for a printed wiring board wherein the adhesive strength between the copper foil and a resin substrate can be enhanced to increase peel strength without deteriorating other properties of the copper foil and without increasing the surface roughness of the copper foil, and a manufacturing method thereof.

### [Solution to Problem]

In order to achieve the above objects, the present inventor conducted intensive studies. As a result, the following copper foils for a printed wiring board and manufacturing methods thereof are provided:
1) A method of manufacturing a copper foil for a printed wiring board, characterized in that a roughened layer of roughing copper grains is formed on at least one surface of the copper foil by using an electrolytic bath of sulfuric acid and copper sulfate, and the electrolytic bath contains tungsten ions and/or arsenic ions and further contains an alkyl sulfate-based anionic surfactant.
2) The method of manufacturing a copper foil for a printed wiring board according to 1), wherein the surfactant is included in an amount of 0.1 to 100 mg/l.
3) The copper foil for a printed wiring board according to any one of 1) to 2), wherein cover plating is performed on the roughened layer in an electrolytic bath of sulfuric acid and copper sulfate.
4) The copper foil for a printed wiring board according to any one of 1) to 3), wherein a heat resistant and rust proof layer containing at least one or more elements selected from zinc, nickel, copper and phosphorus is formed on the roughened layer.
5) The copper foil for a printed wiring board according to 4), wherein a chromate coating layer is formed on the heat resistant and rust proof layer.
6) The copper foil for a printed wiring board according to 5), wherein a layer of a silane coupling agent is formed on the chromate coating layer.
7) A copper foil for a printed wiring board produced by the manufacturing method according to any one of 1) to 6).

### ADVANTAGEOUS EFFECTS OF INVENTION

As described above, the present invention provides significantly advantageous effects. Namely, the copper foil for a printed wiring board of the present invention can provide a copper foil and a manufacturing method thereof which allows enhanced adhesive strength and peel strength between the copper foil and a resin substrate without increasing the surface roughness of the copper foil.
In addition, the copper foil of the present invention is very effective as a copper foil for forming fine wiring of a semiconductor package board and the like having increasingly finer wiring on a printed wiring board and handling increasingly higher frequency in recent years.

### DESCRIPTION OF EMBODIMENTS

Below, the present invention will be described specifically and in detail to facilitate understanding of the present invention. The copper foil used in the present invention may be an electrolytic copper foil or a rolled copper foil.

The method of manufacturing a copper foil for a printed wiring board of the present invention involves forming a roughened layer of roughening copper grains on at least one surface of the copper foil by using electrolytic bath of sulfuric acid and copper sulfate, which contains an alkyl sulfate-based anionic surfactant.
Surfactant is widely and industrially used as an additive for plating. There is an example in which a surfactant is added to an electrolyte solution for roughening treatment of a copper foil for a printed wiring board (WOA12007145164 and others), but no technology has been known which aims to increase adhesive strength by this. As to the alkyl sulfate-based anionic surfactant used in the invention, significant improvement of peel strength has been confirmed.

At present, the effect of the alkyl sulfate-based anionic surfactant cannot be theorized clearly. Nonetheless, it appears that the electrodeposition pattern of roughening grains is changed by coordination of the hydrophilic group of the surfactant, in some form, with a CU ion in an electrolyte solution or by the attachment of a surfactant molecule to a specific site on a surface for electrodeposition. As a result, presumably, current crowding to convex regions on the surface, which has unevenness and are to be subject to electrodeposition, of a copper foil is suppressed, and roughening grains are also uniformly electrodeposited on the concave regions (valley regions of primary grains) on which otherwise roughening grains are not easily electrodeposited. Further, the adherence is improved between the surface for electrodeposition of the copper foil and the electrodeposited roughening grains. As a result, the peel strength has been improved between the copper foil and a resin substrate for a printed wiring board.

A preferred amount of the aforementioned surfactant to be added is 0.1 to 100 mg/l. Although similar effects are obtained even at a concentration higher than this range, the aforementioned range is preferred because foaming of an electrolyte solution becomes significant due to an added surfactant, which makes actual operations difficult. By adding tungsten ions and/or arsenic ions, together with the aforementioned surfactant, to an electrolytic bath for roughening treatment, the adherence (peel strength) can be enhanced between a copper foil and a resin substrate.
Further, cover plating is performed on the aforementioned roughened layer in an electrolytic bath of sulfuric acid and copper sulfate to prevent detachment of the roughening grains and to enhance peel strength. Furthermore, a heat resistant and rust proof layer containing at least one or more elements selected from zinc, nickel, copper, and phosphorus can be formed thereon. In addition, a chromate coating layer can be formed on the aforementioned heat resistant and rust proof layer, and further a layer of a silane coupling agent can be formed on the aforementioned chromate coating layer. According to the above-mentioned manufacturing method, a copper foil for a printed wiring board having the enhanced adherence (peel strength) between the copper foil and a resin can be obtained.

The typical conditions for roughening treatment of the present invention are as follows.
(Liquid composition)
   Cu: 5 to 30 g/L (added as copper sulfate pentahydrate, the same hereinafter)
   H₂SO₄: 10 to 200 g/L
   Sodium dodecyl sulfate: 0.1 to 100 mg/l

(Electroplating conditions)
Temperature: 25 to 60°C
(Electric current conditions)
Current density: 25 to 100 A/dm² (should be equal to or more than the limiting current density of the bath)
The amount of flowing current: 25 to 400 As/dm²

In addition to the aforementioned liquid composition 1, one or both of the following components are added.
(Alternative liquid composition 2)
   As: 0.1 to 2000 mg/L
   W (added as tungstate): 0.1 to 100 mg/l

Further, cover plating is performed on the aforementioned roughened layer in an electrolytic bath of sulfuric acid and copper sulfate. Furthermore, a heat resistant and rust proof layer containing at least one or more elements selected from zinc, nickel, cobalt, copper and phosphorus can be formed, a chromate coating layer can be formed on the aforementioned heat resistant and rust proof layer, and a layer of a silane coupling agent can be formed on the aforementioned chromate coating layer to obtain a copper foil for a printed wiring board.
For cover plating, heat resistant and rust proof treatment, chromate treatment, a silane coupling agent used in combination with the present invention, a conventional heat resistant and rust proof layer can be used.

For cover plating, any known treatments can be used without any particular limitation. A specific example is shown below.
(Liquid composition)
   Cu: 20 to 100 g/L (added as copper sulfate pentahydrate)
   H₂SO₄: 50 to 150 g/L
(Solution temperature)
   25 to 60°C
(Electric current conditions)
   Current density: 1 to 50 A/dm² (should be equal to or less than the limiting current density of the bath)
   Plating time: 1 to 20 seconds

For a heat resistant and rust proof layer, any known treatment can be used without any particular limitation. For example, a conventional brass coating layer can be used for a copper foil for a printed wiring board.
A specific example is shown below.
(Liquid composition)
   NaOH: 40 to 200 g/L
   NaCN: 70 to 250 g/L
   CuCN: 50 to 200 g/L
   Zn(CN)₂: 2 to 100 g/L
   As₂O₃: 0.01 to 1 g/L
(Solution temperature)
   40 to 90°C
(Electric current conditions)
   Current density: 1 to 50 A/dm²
   Plating time: 1 to 20 seconds

For the aforementioned chromate coating layer, an electrolytic chromate coating layer or an immersion chromate coating layer can be used. Preferably, this chromate coating layer has Cr in an amount of 25 to 150 µg/dm².
When the amount of Cr is less than 25 µg/dm², the rust proof layer is not effective. In addition, the Cr content exceeding 150 µg/dm² is pointless since the effect will be saturated. Therefore, the amount of Cr is preferably 25 to 150 µg/dm².
An example of conditions for forming the aforementioned chromate coating layer is described below. However, as described above, any previously known chromate treatments can be used without limited to the conditions. This rust proof treatment is one of the factors which affect acid resistance, and acid resistance is improved by chromate treatment.

### (a) Immersion chromate treatment

K₂Cr₂O₇: 1 to 5 g/L; pH: 2.5 to 5.5; temperature: 25 to 60°C; time: 0. 5 to 8 seconds

### (c) Electrolytic chromium and zinc treatment

K₂Cr₂O₇ (Na₂Cr₂O₇ or CrO₃): 2 to 10 g/L; ZnOH or ZnSO₄·7H₂O: 0.05 to 10 g/L; pH: 2.5 to 5.5; bath temperature: 20 to 80°C; current density: 0.05 to 5 A/dm²; time: 0.1 to 10 seconds

For a silane coupling agent used for the copper foil for a printed wiring board of the present invention, any silane coupling agents usually used for a copper foil can be used without any particular limitation. As an example of treatment by a silane coupling agent, the following conditions are shown.
A 0.2% aqueous epoxy silane solution is sprayed onto a roughened surface of a copper foil and then dried. Any silane coupling agents can be selected, but preferably they are selected after considering an affinity between a copper foil and a resin substrate to be laminated.

### [Examples]

Below, Examples and Comparative Examples will be described. Note that Examples are intended only to illustrate preferred examples, and the present invention is not limited to these Examples. Therefore, any modifications, other embodiments or aspects within the sprit of the present invention are all encompassed within the present invention.
Comparative Examples are provided for comparison with the present invention.

### (Comparative Example 1)

Using an electrolytic copper foil having a thickness of 12 µm, roughening treatment (so-called dendritic plating) shown below was performed on a rough surface (surface roughness Rz: 2.4 µm) of the copper foil. The conditions for roughening treatment are shown below.
(Liquid composition)
   Cu: 15 g/L (added as copper sulfate pentahydrate, the same hereinafter)
   H₂SO₄: 100 g/L
   The added amount of sodium dodecyl sulfate: 10 mg/L
(Solution temperature) 40°C
(Electric current conditions)
   Current density: 50 A/dm²
   The amount of flowing current: 200 As/dm²

Next, cover plating was performed on the aforementioned roughened surface in an electrolytic bath of sulphuric acid and copper sulfate to prevent detachment of roughening grains and to enhance peel strength. The conditions for cover plating are shown below.
(liquid composition for cover plating)
   Cu: 50 g/L (added as copper sulfate pentahydrate, the same hereinafter)
   H₂SO₄: 100 g/L
(Solution temperature) 40°C
(Electric current conditions)
   Current density: 20 A/dm² (less than the limiting current density of the bath)
   The amount of flowing current: 200 As/dm²

Further, a heat resistant and rust proof layer was formed on the aforementioned cover plating treatment, electrolytic chromate treatment was performed on this heat resistant and rust proof layer, and silane treatment (by coating) was further performed on this chromate coating layer.

Following measurements were conducted on the copper foil produced thereby. To measure peel strength, an FR-4 substrate (glass epoxy resin, R-1766 manufactured by Panasonic Electric Works Co., Ltd.) and a BT substrate (bismaleimide triazine resin, GHPL-830 MBT manufactured by Mitsubishi Gas Chemical Company, Inc.) were used for laminate bonding with the copper foil. The BT substrate is a typical substrate for a semiconductor package board. If peel strength of a copper foil laminated on the BT substrate is 0.98 kN/m or more, it can be said that the adhesive strength is sufficient for a copper foil for a semiconductor package board.

### (1) Measurement of surface roughness

The surface roughness of the roughened surface of the copper foil was measured using a stylus-type surface roughness tester.

### (2) Measurement of peel strength

A copper clad laminate was produced by thermal compression of a copper foil and the aforementioned two types of substrates under predetermined conditions, and a circuit having a width of 10 mm was formed via wet etching. Then copper foil was peeled to measure 90-degree peel strength.

The surface roughness and peel strength measured in each Example and each Comparative Example are shown in Table 1.

**[Table 1]**

| | Surfactant Types | Additive Element | Surface Roughness Rz (µm) | FR-4 Peel Strength (kN/m) | BT resin Peel Strength (kN/m) |
|---|---|---|---|---|---|
| Comparative Example 1 | sodium dodecyl sulfate | None | 2.3 | 0.87 | 0.71 |
| Example 1 | sodium dodecyl sulfate | As | 3.0 | 1.22 | 1.12 |
| Example 2 | sodium dodecyl sulfate | W | 2.6 | 1.24 | 1.16 |
| Example 3 | sodium dodecyl sulfate | As+W | 2.7 | 1.34 | 1.36 |
| Example 4 | sodium octyl sulfate | W | 2.5 | 1.19 | 1.09 |
| Example 5 | sodium decyl sulfate | W | 2.8 | 1.18 | 1.10 |
| Example 6 | sodium dodecyl sulfate | W | 2.7 | 1.22 | 1.10 |
| Example 7 | sodium dodecyl sulfate | W | 2.8 | 1.20 | 1.08 |
| Comparative Example 2 | None | None | 2.3 | 0.81 | 0.62 |
| Comparative Example 3 | None | As | 3.1 | 1.12 | 0.98 |
| Comparative Example 4 | None | W | 2.5 | 1.10 | 1.00 |
| Comparative Example 5 | None | As+W | 2.7 | 1.21 | 1.12 |

### (Comparative Example 2)

Sodium dodecyl sulfate was omitted from the electrolyte components for roughening treatment described in Comparative Example 1. Any additives of the present invention were not used. The concentration of components other than the surfactant, solution temperature and plating conditions are the same as in Comparative Example 1. Further, cover plating was performed thereon as in Comparative Example 1. Further surface treatments were also performed as in Comparative Example 1. A bath composition of an electrolyte solution for roughening treatment (plating) is shown below.
(Liquid composition)
   Cu: 15 g/L
   H₂SO₄: 100 g/L

When Comparative Example 1 and Comparative Example 2 are compared, peel strength is increased by adding sodium dodecyl sulfate in Comparative Example 1 while surface roughness is almost the same. However, peel strength is as low as 0.87 kN/m for the BT resin lamination, which is below the practical level sufficient for a printed wiring board.

### (Example 1)

As is added to the electrolyte solution for roughening treatment in Comparative Example 1, and the concentration of components other than As, solution temperature and plating conditions are the same as in Comparative Example 1. Further surface treatments are also performed as in Comparative Example 1. A bath composition of an electrolyte solution for roughening treatment (plating) is shown below.
(Liquid composition)
   Cu: 15 g/L
   H₂SO₄: 100 g/L
   The added amount of sodium dodecyl sulfate: 10 mg/L
   The added amount of As: 1000 mg/L: (added as H₃AsO₃, the same hereinafter)

When Example 1 is compared with Comparative Examples 1 and 2, peel strength is significantly enhanced in Example 1 by adding the alkyl sulfate-based surfactant (sodium dodecyl sulfate) and As while surface roughness is almost the same. The peel strength for the BT resin lamination reached 1.12 kN/m.

### (Comparative Example 3)

Sodium dodecyl sulfate is omitted from the electrolyte components for roughening treatment described in Example 1, which is a known roughening treatment. The concentration of components other than sodium dodecyl sulfate, solution temperature and plating conditions are the same as in Example 1. Further, cover plating was performed thereon as in Example 1. Further surface treatments are also performed as in Example 1.
A bath composition of an electrolyte solution for roughening treatment (plating) is shown below.
(Liquid composition)
   Cu: 15 g/L
   H₂SO₄: 100 g/L
   The added amount of As: 1000 mg/L

When Example 1 is compared with Comparative Example 3, peel strength was significantly enhanced by adding sodium dodecyl sulfate and As in Example 1 while surface roughness was almost the same. The peel strength of the copper foil was able to be significantly enhanced by adding As and the alkyl sulfate-based anionic surfactant into the electrolyte solution for roughening treatment of a copper foil of the present invention.

### (Example 2)

W (tungsten) is added to the electrolyte solution for roughening treatment of Comparative Example 1, and the concentration of components other than W, solution temperature and plating conditions are the same as in Example 1. Further surface treatments are also performed as in Example 1. A bath composition of an electrolyte solution for roughening treatment (plating) is shown below.
(Liquid composition)
   Cu: 15 g/L
   H₂SO₄: 100 g/L
   The added amount of W: 3 mg/L (add as sodium tungstate dihydrate, the same hereinafter)
   The added amount of sodium dodecyl sulfate: 10 mg/L

### (Comparative Example 4)

Sodium dodecyl sulfate is omitted from the electrolyte components for roughening treatment described in Example 2. The concentration of components other than sodium dodecyl sulfate, solution temperature and plating conditions are the same as in Example 1. Further, cover plating was performed thereon as in Example 1. Further surface treatments are also performed as in Example 1. A bath composition of an electrolyte solution for roughening treatment (plating) is shown below.
(Liquid composition)
   Cu: 15g/L
   H₂SO₄: 100 g/L
   The added amount of W: 3 mg/L

When Example 2 is compared with Comparative Example 4, peel strength was increased by adding sodium dodecyl sulfate in Example 2 while surface roughness was almost the same. The peel strength for the BT resin lamination was 1.16 kN/m.
The peel strength of the copper foil was able to be significantly enhanced by adding W and the alkyl sulfate-based anionic surfactant into the electrolyte solution for roughening treatment of a copper foil of the present invention.

### (Example 3)

As and W (tungsten) are added to the electrolyte solution for roughening treatment of Comparative Example 1, and the concentration of components other than As and W, solution temperature and plating conditions are the same as Example 1. Further surface treatments are also performed as in Example 1. A bath composition of an electrolyte solution for roughening treatment (plating) is shown below.
(Liquid composition 4)
   Cu: 15 g/L
   H₂SO₄: 100 g/L
   The added amount of W (tungsten): 3 mg/L
   The added amount of As: 1000 mg/L
   The added amount of sodium dodecyl sulfate: 10 mg/L

### (Comparative Example 5)

Sodium dodecyl sulfate is omitted from the electrolyte components for roughening treatment described in Example 3. The concentration of components other than sodium dodecyl sulfate, solution temperature and plating conditions are the same as in Example 3. Further, cover plating was performed thereon as in Example 1. Further surface treatments are also performed as in Example 1. A bath composition of an electrolyte solution for roughening treatment (plating) is shown below.
(Liquid composition)
   Cu: 15g/L
   H₂SO₄: 100 g/L
   The added amount of W: 3 mg/L
   The added amount of As: 1000 mg/L

When Example 3 is compared with Comparative Example 5, peel strength was significantly increased by adding sodium dodecyl sulfate in Example 3 while surface roughness was almost the same. The peel strength for the BT resin lamination was 1.36 kN/m.

### (Example 4)

Instead of sodium dodecyl sulfate as a component of the electrolyte solution for roughening treatment of Example 2, sodium octyl sulfate, which has less carbon atoms in the alkyl group, is added, and the concentration of components other than sodium octyl sulfate, solution temperature and plating conditions are the same as in Example 2. Further surface treatments are also performed as in Example 2. A bath composition of an electrolyte solution for roughening treatment (plating) is shown below.
(Liquid composition)
   Cu: 15 g/L
   H₂SO₄: 100 g/L
   The added amount of W (tungsten): 3 mg/L
   The added amount of sodium octyl sulfate: 10 mg/L

It is clear that peel strength can also be enhanced by adding an alkyl sulfate-based anionic surfactant other than sodium dodecyl sulfate to an electrolyte solution for roughening treatment when Example 4 is compared with Example 2 .

### (Example 5)

Instead of sodium dodecyl sulfate as a component of the electrolyte solution for roughening treatment of Example 2, sodium decyl sulfate, which has more carbon atoms in the alkyl group, is added, and the concentration of components other than sodium decyl sulfate, solution temperature and plating conditions are the same as in Example 2. Further surface treatments are also performed as in Example 2. A bath composition of an electrolyte solution for roughening treatment (plating) is shown below.
(Liquid composition)
   Cu: 15g/L
   H₂SO₄: 100 g/L
   The added amount of W (tungsten): 3 mg/L
   The added amount of sodium decyl sulfate: 10 mg/L

It is clear that peel strength can also be enhanced in Example 5 by adding an alkyl sulfate-based anionic surfactant other than sodium dodecyl sulfate to an electrolyte solution for roughening treatment when Example 5 is compared and Example 2.

### (Example 6)

The concentration of sodium dodecyl sulfate in the electrolyte solution for roughening treatment of Example 2 is reduced, and the concentration of components other than this, solution temperature and plating conditions are the same as in Example 2. Further surface treatments are also performed as in Example 2. A bath composition of an electrolyte solution for roughening treatment (plating) is shown below.
(Liquid composition)
   Cu: 15 g/L
   H₂SO₄: 100 g/L
   The added amount of W: 3 mg/L
   The added amount of sodium dodecyl sulfate: 0.5 mg/L

When Example 6 is compared with Example 2, even if the concentration of sodium dodecyl sulfate is lower in Example 6, the effects are similar to those of Example 2. However, the lower limit of the concentration of an alkyl sulfate-based anionic surfactant used for the present invention is preferably 0.1 mg/L because the lower limit for quantitative analysis of a surfactant concentration in an aqueous solution is generally about 0.1 mg/L.

### (Example 7)

The concentration of sodium dodecyl sulfate in the electrolyte solution for roughening treatment of Example 2 is increased, and the concentration of components other than this, solution temperature and plating conditions are the same as in Example 2. Further surface treatments are also performed as in Example 2. A bath composition of an electrolyte solution for roughening treatment (plating) is shown below.
(Liquid composition)
   Cu: 15 g/L
   H₂SO₄: 100 g/L
   The added amount of W: 3 mg/L
   The added amount of sodium dodecyl sulfate: 100 mg/L

When Example 7 is compared with Example 2, even if the concentration of sodium dodecyl sulfate is higher in Example 7, the effects are similar to those of Example 2. However, If the surfactant concentration in an aqueous solution further increases, foaming of an electrolyte solution will significantly increase. Thus a further increased concentration is not realistic for actual operations in industry. Accordingly, the upper limit of the concentration of an alkyl sulfate-based anionic surfactant used for the present invention is preferably 100 mg/L.

As demonstrated above, the present invention has significantly advantageous effects of allowing for provision of the copper foil for a printed wiring board of the invention, which is a copper foil of which the adhesive strength with a resin can be enhanced without increasing a profile of a roughened surface, and the peel strength can be increased thereby; and provision of a manufacturing method thereof.

### INDUSTRIAL APPLICABILITY

As shown above, the present invention provides significantly advantageous effects. Namely the adhesive strength of a copper foil itself with a resin substrate can be significantly enhanced by forming roughening grains of the present invention on at least one surface of the copper foil.
Further, the present invention is very effective as a copper foil for a semiconductor package board and a liquid crystal polymer board in which an increasingly finer circuit and increasingly higher frequency are required.

## Claims

1. A method of manufacturing a copper foil for a printed wiring board, **characterized in that** a roughened layer of roughening copper grains is formed on at least one surface of the copper foil by using an electrolytic bath of sulfuric acid and copper sulfate, and the electrolytic bath contains tungsten ions and/or arsenic ions and further contains an alkyl sulfate-based anionic surfactant.

2. The method of manufacturing a copper foil for a printed wiring board according to claim 1, wherein the surfactant is contained in an amount of 0.1 to 100 mg.

3. The copper foil for a printed wiring board according to any one of 1 to 2, wherein cover plating is performed on the roughened layer in an electrolytic bath of sulfuric acid and copper sulfate.

4. The copper foil for a printed wiring board according to any one of claims 1 to 3, wherein a heat resistant and rust proof layer containing at least one or more elements selected from zinc, nickel, copper and phosphorus is formed on the cover-plated layer.

5. The copper foil for a printed wiring board according to claim 4, wherein a chromate coating layer is formed on the heat resistant and rust proof layer.

6. The copper foil for a printed wiring board according to claim 5, wherein a layer of a silane coupling agent is formed on the chromate coating layer.

7. A copper foil for a printed wiring board produced by the manufacturing method according to any one of claims 1 to 6.
